# EUROPEAN PATENT APPLICATION

(11) **EP 4 592 375 A1**
(43) Date of publication of application: **30.07.2025**
(21) Application number: 24154048.3
(22) Date of filing: 25.01.2024
(51) Int. Cl.: C09K 11/66

(54) **NANOCRYSTAL ASSEMBLY**

(71) Applicant: Ludwig-Maximilians-Universität München, 80539 München (DE)
(72) Inventor: URBAN, Alexander, 82061 Neuried (DE); NICKEL, Bert, 85737 Ismaning (DE); LEO, Ulrich, 80796 München (DE)
(74) Representative: Tautz & Schuhmacher

(57) **Abstract**

The disclosure concerns a method (200) of manufacturing a nanocrystal (NC) assembly (10), comprising: providing (210) nanocrystals (NCs), mixing (220) the nanocrystals (NCs) with an alkyl carboxylic acid, an alkyl amine and/or an alkyl alcohol, wherein at least one of the alkyl carboxylic acid, alkyl amine, and alkyl alcohol is unsaturated, to obtain ligand-mixed nanocrystals (NCs), and subjecting (230) the ligand-mixed nanocrystals (NCs) to a collimated electron beam to obtain the nanocrystal (NC) assembly. The disclosure further concerns a nanocrystal (NC) assembly (10) obtained by the present method, a direct-gap semiconductor (300) comprising the present nanocrystal (NC) assembly (10), a light-emitting diode (310) comprising the present nanocrystal (NC) assembly (10) or the present direct-gap semiconductor (300), and a solar cell (320) comprising the present nanocrystal (NC) assembly (10) or the present direct-gap semiconductor (300).

## Description

The present disclosure relates to the field of solar cells. In particular, the present disclosure discloses a method of manufacturing a nanocrystal (NC) assembly, a nanocrystal (NC) assembly, a direct-gap semiconductor, a light-emitting diode, a solar cell, and a use of a collimated electron beam for enhancing a stability of nanocrystals (NCs).

Nanocrystals (NCs), such as Perovskite nanocrystals (PNCs), have emerged as highly promising materials both for solar light harvesting integrated into solar cells or as photocatalysts or for light emission in LEDs or as downconverters (A. Kojima, K. Teshima, Y. Shirai, T. Miyasaka, J. Am. Chem. Soc. 2009, 131, 6050; K. Lin, J. Xing, L. N. Quan, F. P. G. de Arquer, X. Gong, J. Lu, L. Xie, W. Zhao, D. Zhang, C. Yan, W. Li, X. Liu, Y. Lu, J. Kirman, E. H. Sargent, Q. Xiong, Z. Wei, Nature 2018, 562, 245; and D. Yang, X. Zhou, R. Yang, Z. Yang, W. Yu, X. Wang, C. Li, S. Liu, R. P. H. Chang, Energy & Environmental Science 2016, 9, 3071, the contents of which are incorporated by way of reference). Particularly, lead and tin halide Perovskites have garnered significant attention in recent years as cost-effective and versatile direct-gap semiconductors for LEDs and solar cells.

As a direct semiconductor, nanocrystals (NCs), particularly Perovskite nanocrystals (PNCs), offer remarkable absorption and emission properties and a potential for near-unity photoluminescence quantum yield (PLaY) (Y. Hassan, Y. Song, R. D. Pensack, A. I. Abdelrahman, Y. Kobayashi, M. A. Winnik, G. D. Scholes, Adv. Mater. 2016, 28, 566; S. T. Ha, X. Liu, Q. Zhang, D. Giovanni, T. C. Sum, Q. Xiong, Adv. Opt. Mater. 2014, DOI: 10.1002/adom.201400106n/a; Q. A. Akkerman, V. D'lnnocenzo, S. Accornero, A. Scarpellini, A. Petrozza, M. Prato, L. Manna, J. Am. Chem. Soc. 2015, 137, 10276; L. Protesescu, S. Yakunin, M. I. Bodnarchuk, F. Krieg, R. Caputo, C. H. Hendon, R. X. Yang, A. Walsh, M. V. Kovalenko, Nano Lett. 2015, 15, 3692; S. De Wolf, J. Holovsky, S.-J. Moon, P. Löper, B. Niesen, M. Ledinsky, F.-J. Haug, J.-H. Yum, C. Ballif, J. Phys. Chem. Lett. 2014, 5, 1035; and Q. A. Akkerman, G. Raino, M. V. Kovalenko, L. Manna, Nat. Mater. 2018, 17, 394, the contents of which are incorporated by way of reference).

Their facile synthesis, as well as excellent tuning possibilities via particle size tuning and composition, make them attractive for future large-scale applications. However, their instability under ambient conditions, including instability against the atmosphere, water, and temperature, poses a significant challenge for their implementation in any large-scale application (H. W. Huang, B. Pradhan, J. Hofkens, M. B. J. Roeffaers, J. A. Steele, ACS Energy Letters 2020, 5, 1107; S. Kar, N. F. Jamaludin, N. Yantara, S. G. Mhaisalkar, W. L. Leong, Nanophotonics-Berlin 2021, 10, 2103; N. G. Park, Mater. Today 2015, 18, 65; and J. A. Christians, P. A. Miranda Herrera, P. V. Kamat, J. Am. Chem. Soc. 2015, 137, 1530, the contents of which are incorporated by way of reference) and remains the reason why it has yet to prevail against silicon solar cells with a 20-year lifetime. Extensive research has been devoted to addressing those issues.

A popular approach for increasing their stability is the encapsulation of the NC in a micelle (S. Hou, Y. Guo, Y. Tang, Q. Quan, ACS Applied Materials & Interfaces 2017, 9, 18417, and Q. Xue, C. Lampe, T. Naujoks, K. Frank, M. Gramlich, M. Schoger, W. Vanderlinden, P. Reisbeck, B. Nickel, W. Brütting, A. S. Urban, Adv. Opt. Mater. 2022, 10, 2102791) or a polymer matrix (G. Li, Z.-K. Tan, D. Di, M. L. Lai, L. Jiang, J. H.-W. Lim, R. H. Friend, N. C. Greenham, Nano Lett. 2015, 15, 2640; and S. N. Raja, Y. Bekenstein, M. A. Koc, S. Fischer, D. Zhang, L. Lin, R. O. Ritchie, P. Yang, A. P. Alivisatos, ACS Applied Materials & Interfaces 2016, 8, 35523, the contents of which are incorporated by way of reference). While this may enhance the stability, charge transport is severely impeded. An alternative approach involves the deposition of an additional protective layer above the NCs. This, however, complicates the production process and changes charge injection into the perovskite layer.

Still another approach employs x-ray irradiation to enhance the stability of cesium lead halide nanocrystal films by inducing the formation of C=C double bonds between oleylamine and oleic acid ligands (F. Palazon, Q. A. Akkerman, M. Prato, L. Manna, ACS Nano 2016, 10, 1224, the content of which is incorporated by way of reference).

The methods of the prior art have the drawback of producing nanocrystal films of inconsistent quality and with a limited lifetime. Moreover, a mechanical stability of conventional nanocrystal films is often poor and does not allow for a free-standing nanocrystal film separate from a rigid substrate.

The present disclosure seeks to overcome the drawbacks mentioned above. An objective of the present disclosure is the provision of a nanocrystal assembly that may be reliably produced with large dimensions rendering it suitable for technical and/or industrial applications, such as solar cell production. Another objective is the provision of a nanocrystal assembly with consistent quality over the entire assembly and/or a sufficient lifetime for different applications, e. g. solar cell manufacturing. Still another objective is the provision of a method of producing such a nanocrystal assembly.

It is therefore desirable to provide a solution by means of which a nanocrystal assembly may be produced, wherein the assembly has large dimensions and fulfils the demands of efficient direct-gap semiconductors such that they may be used in light-emitting diodes or solar cells. Another objective resides in the provision of a method of producing a nanocrystal assembly with high stability against environmental influences, solvents, consistent quality, and/or high lifetime. Still another objective resides in the provision of a method of producing a nanocrystal assembly, wherein an outer surface is protected against environmental influences and said outer surface, whilst the interior of the assembly is chemically unaffected, thus functions in a conventional manner.

This is solved by the objects of the independent claims. Advantageous embodiments are indicated in the dependent claims and in the description.

In a first aspect, a method of manufacturing a nanocrystal (NC) assembly is provided. The method comprises providing nanocrystals (NCs), mixing the nanocrystals (NCs) with an alkyl carboxylic acid, an alkyl amine and/or an alkyl alcohol, wherein at least one of the alkyl carboxylic acid, alkyl amine, and alkyl alcohol is unsaturated, to obtain ligand-mixed nanocrystals (NCs), and subjecting the ligand-mixed nanocrystals (NCs) to a collimated electron beam to obtain the nanocrystal (NC) assembly.

In a further aspect, a nanocrystal (NC) assembly obtained by the present method is provided.

In still a further aspect, a direct-gap semiconductor comprising the present nanocrystal (NC) assembly is provided.

In another aspect, a light-emitting diode comprising the present nanocrystal (NC) assembly or the present direct-gap semiconductor according to the disclosure, or a solar cell comprising the present nanocrystal (NC) assembly or the present direct-gap semiconductor is provided.

In still another aspect, a use of a collimated electron beam for enhancing a stability of nanocrystals (NCs) is provided, wherein the nanocrystals (NCs) are coated with an alkyl carboxylic acid, an alkyl amine, and/or an alkyl alcohol, wherein at least one of the alkyl carboxylic acid, alkyl amine, and alkyl alcohol is unsaturated.

The nanocrystals optionally comprise or consist of Perovskite nanocrystals (PNCs). Said Perovskite nanocrystals (PNCs) may be used for the preparation of a Perovskite nanocrystal (PNC) assembly.

A nanocrystal (NC) is a material particle offering electronic and/or optical properties governed at least partly by quantum confinement. In other words, the electronic and/or optical properties of a nanocrystal may be governed partly or entirely by the spatial dimensions of the nanocrystal instead of its bulk material properties. A nanocrystal may have an extension in at least one spatial dimension of 1 µm or less, optionally 500 nm or less, optionally 100 nm or less, such as 1 nm to 100 nm, 10 nm to 60 nm, 20 nm to 50 nm, or 30 nm to 40 nm. In addition, the extension of the nanoparticle in each spatial dimension may be at least 1 nm. At least one extension of the nanoparticles in the spatial dimensions optionally may be in a range from 1 nm to 100 nm, optionally from 5 nm to 30 nm, and optionally from 10 nm to 20 nm. The nanoparticle may represent a quantum dot and may be composed of atoms in a single- or poly-crystalline arrangement. Exemplary nanocrystals include nanorods and/or nanoplatelets.

A Perovskite is any material with a crystal structure, often cubic or distorted cubic, and having a composition following the general formula ABX, wherein A and B are each atoms with a positive charge, and X atoms with a negative charge. A, B, and X may be, independently of each other, composed of different atoms of the same valency. Nanocrystals (NCs) according to an optional embodiment may comprise ABClₓBr_{y}I_{z} with A = Rb and/or Cs, B = Pb and/or Sn, 0 ≤ x ≤ 3, 0 ≤ y ≤ 3, and 0 ≤ z ≤ 3 with the proviso that x + y + z = 3. Because of the high surface-to-volume ratio, the optical and optoelectronic performance, and the colloidal stability of nanocrystals (NCs) may depend on their surface chemistry, especially the ligands and surface termination. On the one hand, the capping ligands may improve the colloidal stability and luminescence; on the other hand, the highly dynamic binding nature of ligands may be detrimental to the colloidal stability and photoluminescence of the nanocrystals (NCs). In addition, a surface functionalization with desired molecules may introduce new functionalities such as chirality, light harvesting, and triplet sensitization through energy/electron transfer or use as X-ray detectors.

The mixing may encompass an alkyl carboxylic acid, an alkyl amine, and/or an alkyl alcohol, wherein at least one of the alkyl carboxylic acid, alkyl amine, and alkyl alcohol is unsaturated. Optionally, an alkyl residue may be employed having at least one amine group and at least one hydroxyl group. Optionally, the mixing comprises providing a mixture of at least two of an alkyl carboxylic acid, an alkyl amine, and an alkyl alcohol, such a mixture of an alkyl carboxylic acid and an alkyl amine. Any of the alkyl carboxylic acid, alkyl amine, and/or alkyl alcohol may form ligands to the nanocrystals (NCs). Because of the high surface-to-volume ratio, the optical and optoelectronic performance, and the colloidal stability of nanocrystals (NCs) may largely depend on their surface chemistry, especially the ligands and surface termination. On the one hand, the capping ligands improve the colloidal stability and luminescence, on the other hand, the highly dynamic binding nature of ligands is detrimental to the colloidal stability and photoluminescence of NCs. In addition, the surface functionalization with desired molecules induces new functionalities such as chirality, light harvesting, and triplet sensitization through energy/electron transfer or use as X-ray detectors.

An electron beam may be generated using an electron gun, which may comprise a cathode ray tube. In such a device, the electrons are released from a hot cathode and accelerated by an electric field. Further acceleration can be achieved with particle accelerators, such as a linear accelerator, betatron, microtron, and synchrotron. Methods for generating electron beams are well known in the art.

A collimated electron beam has an essentially parallel trajectory of the electrons forming the electron beam, and therefore will spread minimally, essentially due to dispersion, as it propagates. A collimated electron beam, particularly a collimated electron beam that passes a beam expander, may be used for irradiating large areas under consistent conditions, i. e. affording consistent energy output per surface unit. A collimated electron beam may be generated by passing an electron beam through a collimator, such as a Wehnelt cylinder. Collimators for generating collimated electron beams are well known in the art. A spot size or cross-sectional size of the collimated electron beam may be 1 mm² or more, optionally 2 mm², and optionally 3 mm² or more. An electron beam may be regarded as collimated when an angle of divergence and/or an angle of convergence angle of the collimated electron beam is 2° or less.

The size of nanoparticles, particularly nanocrystals (NCs), may be provided by D50 values. D50 is a corresponding particle size when a cumulative volume percentage of the active material reaches 50%, that is, a median particle size in volume distribution. D50 may be measured by using a ZEISS Ultra Plus scanning electron microscope (SEM) operating at 3 keV, usually according to the manufacturer's instructions.

The layer thickness may be by using a ZEISS Ultra Plus scanning electron microscope (SEM) operating at 3keV, usually according to the manufacturer's instructions. A layer thickness distribution of the nanocrystals (NCs), such as nanoplatelets and/or nanorods, may involve ten nanocrystals (NCs) selected at random and calculating the median layer thickness distribution therefrom.

The disclosure offers the advantage that the ligands of the PNCs are cross-linked with each other, such that a protective film/layer is formed around the PNCs, resulting in the PNC assembly. Without limitation to any theory, it is assumed that carbon bonds, particularly C=C double bonds, in the ligands, such as oleylamin and oleic acid ligands, may be broken during the ligand cross-linking process and inter-ligand C=C double bonds may emerge, which may give rise to a ligand network protecting the perovskite layer(s). This may allow providing the nanocrystal assemblies with an enhanced stability as compared to conventional nanocrystal assemblies.

Another optional advantage resides in that the collimated electron beam may allow radiating relatively large layers of ligand-mixed PNCs with essentially equal intensities and/or penetration depth of the electron beam, which results in a PNC assembly having essentially consistent properties over the entire layer(s). It is assumed that this is due to an essentially equal reaction range over the entire layer. Furthermore, in contrast to conventional light-based cross-linking, including e. g. cross-linking via non-collimated X-rays and UV-radiation, and/or chemical cross-linking, using e. g. a catalyst, it is assumed that the penetration depth of the collimated electron beam is controllably limited and/or essentially constant, thus leaving the inner layers of the PNCs and their ligands and their function unaffected. The outer cross-linked layer may protect one or more inner layers and ensures the propagation of light therethrough, such that the light reaches the inner layers.

This may result in significantly improved layer lifetimes with an increase in photoluminescence (PL) in ambient conditions over time and remarkable changes of the surface layer to a hydrophobic state, a considerable resistance of the nanocrystal layer to solvents, and the possibility of heterostructure production, resulting in two distinct spectral PL peaks without ion transfer. This further enables a perovskite NC layer wet transfer enabling a suspended perovskite NC foil. Another advantage may reside in that halide ions are retained in the structure.

Moreover, the disclosure provides the advantage that the collimated electron beam may be provided with a significantly larger spot size, such as 1 mm² or more, than conventionally used focused electron beams of a lithography device, which may only provide a spot size having a diameter of about 10 nm. This allows irradiating larger areas at the same time and therefore for the reduction of the required time for exposing a target area to the electron beam. This may reduce the required processing time and the processing costs.

The disclosure may further provide the advantage of lower costs as compared to conventional setups based on X-rays for providing radiation for providing a cross-linking reaction. Moreover, using a collimated electron beam may significantly increase the safety and reduce a danger of subjecting the surroundings to hazardous radiation as compared to X-rays. In addition, using a collimated electron beam may improve an adjustability of the penetration depth of the electron beam as compared to X-radiation, which may, thus, improve the achievable precision of the cross-linking reaction.

The approach underlying the present disclosure may be demonstrated by employing highly confined CsPbBrs 2 monolayer (ML) thick nanoplatelets (NPLs) and 3 ML thick nanorods, with an advantageous potential for blue emission but also a very low stability under ambient conditions. A collimated electron radiation may break up carbon bonds in the ligands. Subsequently, inter-ligand C=C double bonds may emerge, transforming the ligand-mixed, optionally spin-mixed, PNC layer into a highly rigid and stable film. The electron dosage may be tuned such that the stability of the PNC film can be substantially increased to a desired level, while retaining its high optical quality. The film/assembly remains essentially unchanged after several weeks, optionally six weeks or more, such as two months, in ambient atmosphere (i. e. under ambient conditions at e. g. a temperature of 20°C to 22°C, an atmospheric pressure of 101,325 kPa ± 30 kPa, and/or 30-40% humidity) and are impervious to many solvents, including n-hexane and water. Importantly and notably, the films/ assemblies become impermeable for halide ions, enabling the formation of otherwise unattainable PNC heterostructures.

Optionally, the nanocrystal (NC) assembly is not subjected to any chemical cross-linking reaction, employing e. g. a catalyst, and/or a cross-linking reaction comprising radiation that does not originate from a collimated electron beam.

Optionally, the nanocrystals (NCs) are Perovskite nanocrystals (PNCs) and/or are in form of nanorods and/or nanoplatelets. Nanorods are one morphology of nanoscale objects. Each of their dimensions may be in a range from 1 nm to 100 nm, optionally 2 nm to 50 nm, such as 3 nm to 25 nm, 4 nm to 20 nm, and 5 nm to 10 nm. An aspect ratio (length : width) of a nanorod is usually about 4 to about 10, optionally about 5 to about 9. Nanorods may be synthesized from a semiconducting material or metal. For instance, they may be produced by direct chemical synthesis, wherein ligands can act as shape control agents and bond to different facets of the nanorod with different strengths. This allows different faces of the nanorod to grow at different rates, producing an elongated object. Nanoplatelets have at least one lateral dimension, assessed as a number average, optionally a median number average, of 5 nm or more, such as 5 nm to 100 nm, 7 nm to 50 nm, and optionally 10 nm to 20 nm. Exemplary nanoplatelets can have a length and width of 15 nm each. Optionally, the nanoplatelets have a footprint area, i. e. the area of one of the larger faces of the nanoplatelets when viewed in top view, assessed as a number average, in a range from 10 nm² to 1.000 nm²_{'} optionally from 100 nm² to 300 nm², and optionally from 150 nm² to 250 nm². Nanoplatelets may be single layer nanoplatelets or few layer nanoplatelets, such as about 2 to about 20 layers, about 3 to about 15 layers, about 4 to about 10 layers, or about 5 to about 8 layers. In commercially available products, there may be a mixture of single layer and few layer nanoplatelets. Nanoplatelets may be selected from one or more of elemental material, such as graphene that is typically derived from pristine graphite, a metallic material, a semi-metallic material, a semiconductor, an insulator, or a superconductor. Other materials may be applied as the nanoplatelets. Preferred nanoplatelets are exfoliated graphite nanoplatelets (GnPs), i. e. nanoparticles that may be made from graphite. Exfoliated graphite nano-platelets (GNPs) may be stacks of graphene that are about 1 to about 15 nanometers thick, with diameters ranging from about 1 nm to about 100 µm, such about 10 nm to about 10 µm, 100 nm to about 1 µm, or 200 nm to about 500 nm. Nanoplatelets and nanorods have the advantage that they can be modified with ligands that allow the properties of the nanoplatelets and/or nanorods to be controlled.

Optionally, the nanocrystals (NCs) are Perovskite nanocrystals (PNCs) that comprise ABClₓBr_{y}I_{z} with A = Rb or Cs, B = Pb or Sn, 0 ≤ x ≤ 3, 0 ≤ y ≤ 3, and 0 ≤ z ≤ 3 with the proviso that x + y + z = 3, optionally wherein A is Cs, B is Pb, and one of x, y, or z is 3, more optionally wherein the nanocrystals (NCs) comprise, or essentially consist of, CsPbI₃. nanocrystals (NCs) of the general composition ABClₓBr_{y}I_{z} have the advantage that, in addition to the broad variation possibilities of the chemical composition, they may be easily modified by selecting organic ligands.

Optionally, the alkyl carboxylic acid, the alkyl amine, and the alkyl alcohol comprise 12 to 22 C-atoms each. The alkyl amine optionally comprises, or essentially consists of, oleylamine and/or the unsaturated alkyl carboxylic acid comprises, or essentially consists of, oleic acid. Optionally, the alkyl alcohol is not present. Still optionally, the alkyl carboxylic acid, the alkyl amine, and the alkyl alcohol comprise independently from each other 14 to 20 C-atoms, such as 16 to 18 C-atoms. Influencing the length, the position, and number of double bounds has the advantage of easily modifying the optical properties of the nanocrystal (NC) assembly as well as the degree and position of cross-linked ligands.

Optionally, a volume ratio of the alkyl amine, and/or the alkyl alcohol to the alkyl carboxylic acid is from about 1:2 to about 2:1, optionally about 1:1. In particular, the volume ratio of the alkyl amine to the alkyl carboxylic acid is from about 1:2 to about 2:1, optionally about 1:1, or the volume ratio of the alkyl alcohol to the alkyl carboxylic acid is from about 1:2 to about 2:1, optionally about 1:1, or the volume ratio of the alkyl amine and the alkyl alcohol to the alkyl carboxylic acid is from about 1:2 to about 2:1, optionally about 1:1.

Optionally, the nanocrystal (NC) assembly is resistant to washing with polar solvents and apolar solvents, wherein the polar solvents include solvents with a polarity that is lower than the polarity of water and the apolar solvents include solvents with a polarity that is higher than the polarity of n-hexane. This has the advantage that the present assembly may be easily washed, purified, and/or released/ stripped off from a substrate, such as a silicon wafer that is optionally coated.

Optionally, subjecting the ligand-mixed nanocrystals (NCs) to a collimated electron beam comprising exposing the ligand-mixed nanocrystals (NCs) to a dose of about 5 × 10² µC/cm² to about 2 × 10⁴ µC/cm², optionally about 2 × 10³ µC/cm² to about 10⁴ µC/cm², more optionally about 6 × 10³ µC/cm². This has the advantage that the properties of the protective layer, particularly the degree of cross-linking and/or the depth of cross-linked ligands, such as one (mono)layer or more, two (mono)layers or more, or three monolayers to five (mono)layers may be easily adjusted.

Optionally, the method further comprises providing additional nanocrystals (NCs) on the nanocrystal (NC) assembly. The additional nanocrystals (NCs) can encompass ligand-mixed nanocrystals (NCs), such as nanoplatelets and/or nanorods, or can be nanocrystals (NCs) as such that are coated with ligands, e. g. with the alkyl amine, the alkyl alcohol, and/or the alkyl carboxylic acid, and/or any other suitable ligand. Thereby a layer structure may be established wherein one or more of the outer (mono)layers, such as two of the outer (mono)layers, three of the outer (mono)layers, four of the outer (mono)layers, or five of the outer (mono)layers, are subjected to a collimated electron beam and form a protective coating. Said protective coating shields one or more internal (mono)layers, which are supposed to remain untreated, i. e. not subjected to the collimated electron beam. The number of the one or more internal (mono)layers is not particularly limited and may include 2 to 200, such as 3 to 100, 4 to 50, 5 to 40, or 10 to 30 internal (mono)layers.

Optionally, providing nanocrystals (NCs) comprises depositing the nanocrystals (NCs) on a substrate, particularly a silicon substrate. This has the advantage that the properties of the protective layer and the properties of the internal layer may be easily modified.

Optionally, the substrate is a silicon substrate, wherein a surface of the silicon substrate, on which the nanocrystals (NCs) are to be deposited, has a photoresist layer, optionally a poly(methyl 2-methylpropanoate) (PMMA) photoresist layer. This has the advantage that the structure/ assembly of one or more internal layers, which are shielded or sandwiched by one or more protective layers, may be easily prepared, washed/ purified, and/or released from the substrate in a ready to use state.

Optionally, depositing the nanocrystals (NCs) includes spin-coating or drop-casting. Spin-coating or drop-casting are well known techniques. Spin-coating may be a procedure that may be used to deposit uniform thin films onto flat substrates. Usually a small amount of mixing material is applied at the center of the substrate, which is either spinning at low speed or not spinning at all. The substrate is then rotated at speeds up to about 10,000 rpm, such as about 5,000 rpm to about 8,000 rpm, to spread the mixing material by centrifugal force. Drop casting can involve pouring a solution onto the substrate as droplets and allowing the droplets to dry out without spreading; when the drops are projected onto the substrate, the liquid initially spreads from the drop sites across the surface due to the interfacial forces which tend to drive the droplet outwards. As multiple droplets were projected onto the substrate surface, when the edges of the droplets come into contact with each other, they mix to form a non-circular drop with a, essentially, concave contact line. Spin-coating is preferred.

Optionally, the nanocrystals (NCs) are deposited with a thickness in a range from about 10 nm to about 300 nm and optionally in a range from about 20 nm to about 150 nm, wherein the thickness is measured according to the description. Optionally, the thickness may be adjusted calculated from the amount of nanocrystals (NCs) to be deposited on a surface area of known dimensions. It is assumed that cross-linking of the ligands does not have an impact on the thickness.

Optionally, the method further comprises stripping off the nanocrystal (NC) assembly from the substrate. Stripping off may be performed by e. g. using solvents, such as acetone. This has the advantage that ready to use nanocrystal (NC) assemblies for e. g. a direct-gap semiconductor, a light-emitting diode, and/or a solar cell may be easily prepared.

Optionally an electron gun may be used for providing the collimated electron beam. This may provide the advantage that the collimated electron beam may be provided at considerably lower costs than the conventionally used lithography devices. Thus, this may reduce the costs for subjecting the ligand-mixed nanocrystals to the electron beam to obtain the nanocrystal assembly. Moreover, this may provide the advantage that electron beams may be provided at significantly higher electric currents as compared to conventionally used lithography devices. The electron beam may be provided at an electrical current of 300 µA or more, optionally 1 mA or more, and optionally 10 mA or more, which is significantly higher than typical electrical currents of several hundreds of Nano-Amperes provided by lithography devices. Therefore, the required time for applying a specific dose of electron beam to a target surface may be several orders of magnitudes lower than when using a lithography device. In addition, this may provide the advantage that the electron beam may be provided with an electron energy of about 300 V as compared to lithography devices providing electrons at an electron energy of several keV, such as 10 keV. The lower electron energy may provide the advantage the electron beam may be provided with a lower penetration depth, which may avoid or reduce undesired damages to the PNCs.

Subjecting the ligand-mixed nanocrystals to a collimated electron beam to obtain the nanocrystal assembly may comprise subjecting a first surface of the ligand-mixed nanocrystals to the collimated electron beam and subjecting a second surface of the ligand-mixed nanocrystals to the collimated electron beam, wherein the second surface is different from the first surface. The second surface may be opposite to the first surface. Optionally, the first and the second surface may be arranged on different sides of the nanocrystal assembly, such that a nanocrystal assembly may be sandwiched between to layers formed by subjecting the ligand-mixed nanocrystals to the collimated electron beam. This may allow providing a NC assembly having a high mechanical stability and optionally allowing providing a free-standing NC assembly.

Subjecting the ligand-mixed nanocrystals from a first surface and a second surface to the collimated electron beam may be performed in a consecutive manner, i. e., subjecting the first surface to the electron beam and then subjecting the second surface to the collimated electron beam or vice versa. Alternatively or additionally, more than one electron beams may be provided to subject the first and the second surface of the ligand-mixed nanocrystals to the electron beam at the same time. Accordingly, a NC assembly may be provided having a cross-linked section at a first surface and at a second surface and a NC assembly without crosslinking arranged between the first and the second surface. The process of subjecting the ligand-mixed nanocrystals from the second side to the collimated electron beam may be performed in the same or in a different manner as compared to subjecting the ligand-mixed nanocrystals from the first side to the collimated electron beam. For subjecting the ligand-mixed nanocrystals from both sides to the collimated electron beam, the ligand-mixed nanocrystals may be supported by a thin and yet stable support layer allowing the collimated electron beam at least partially to be transmitted through the support layer. Alternatively or additionally, the ligand-mixed nanocrystals may be at least partially frozen in order to change a position and/or an orientation of the ligand-mixed nanocrystals for subjecting the second surface to the collimated electron beam after subjecting the first surface of the ligand-mixed nanocrystals to the collimated electron beam. Freezing the ligand-mixed nanocrystals may increase the mechanical stability of the ligand-mixed nanocrystals in order to allow changing the position and/or orientation of the ligand-mixed nanocrystals.

Further details and advantages will now be explained in more detail with reference to the following examples and optional embodiments with reference to the figures.
Fig. 1 shows the general concept of generating a nanocrystal (NC) assembly;
Fig. 2 shows Photoluminescence intensity development over time or over dose;
Fig. 3 shows the stability of a nanocrystal (NC) assembly;
Fig. 4 schematically depicts a process of manufacturing a nanocrystal (NC) assembly;
Fig. 5 schematically shows a method of manufacturing a nanocrystal (NC) assembly with enhanced stability; and
Fig. 6 schematically shows a direct-gap semiconductor, a light-emitting diode, a solar cell that are obtained from a nanocrystal (NC) assembly with enhanced stability.

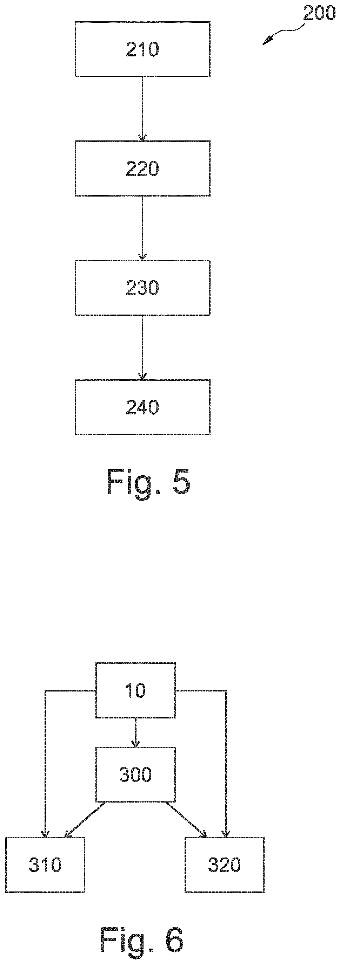

Firstly, referring to Fig. 5, a method (200) of manufacturing a nanocrystal (NC) assembly (10) with enhanced stability is shown. The method comprises: providing (210) nanocrystals (NCs), mixing (220) the nanocrystals (NCs) with a mixture of an alkyl carboxylic acid with an alkyl amine and/or alkyl alcohol, wherein at least one of the alkyl carboxylic acid, alkyl amine, and alkyl alcohol is unsaturated, to obtain ligand-mixed nanocrystals (NCs), and subjecting (230) the ligand-mixed nanocrystals (NCs) to a collimated electron beam to obtain the nanocrystal (NC) assembly (10). The method optionally comprises the step of providing additional nanocrystals (NCs) (240) on the nanocrystal (NCs) assembly (10). Said step of providing additional nanocrystals (NCs) (240) may include ligand-mixed nanocrystals (NCs) and may be succeeded by subjecting the ligand-mixed nanocrystals (NCs) to a collimated electron beam to obtain the nanocrystal (NC) assembly (10).

Fig. 6 schematically shows that the present nanocrystal (NC) assembly (10) can be used as such for manufacturing a direct-gap semiconductor (300), a light-emitting diode (310), and/or a solar cell (320). Alternatively, a light-emitting diode (310), and/or a solar cell (320) may be produced from a direct-gap semiconductor (300) that comprises the present nanocrystal (NC) assembly (10).

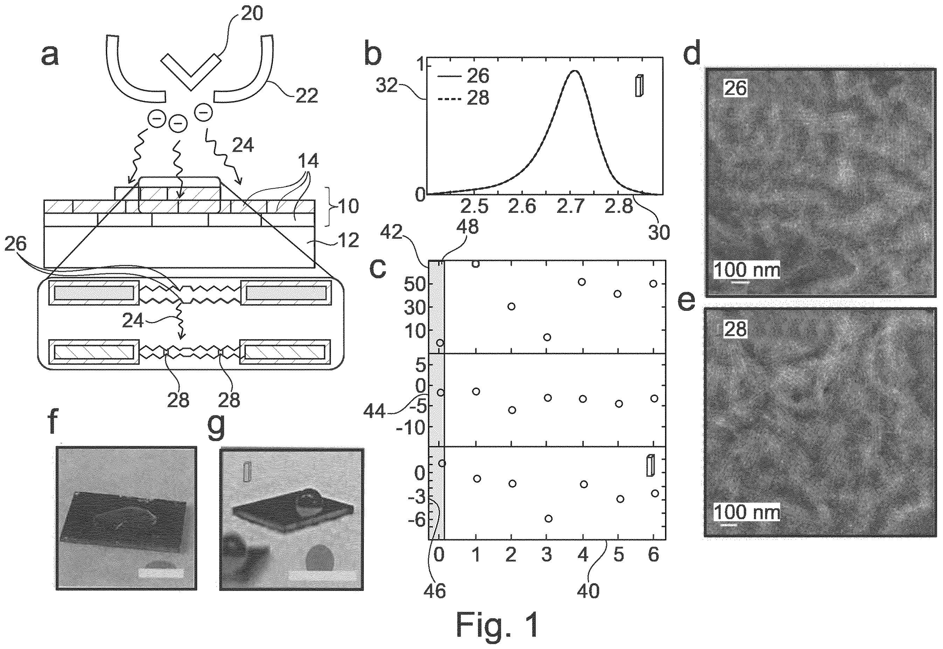

The following explanations provide further exemplary information without limiting the scope of the disclosure:
With reference to Fig. 1, the concept underlying the present disclosure is generally shown in Figure 1a. Electrons emitted by a cathode 20 are focused by a Wehnelt cylinder 22 onto a substrate 12, where they break up the intra-ligand carbon bonds, and inter-ligand double bonds emerge. Due to low penetration depth, only the uppermost layers of NPLs 14 become a protective network forming a PNC assembly 10. Fig. 1b shows exemplary normalized photoluminescence (PL) spectra of a 3 ML nanorod before 26 and after the cross-linking 28, wherein the horizontal axis shows the energy 30 in eV and the vertical axis shows the normalized PL 32 as percentage. Neither a change of the full width at half maximum (FWHM) nor a change of the peak position occurs, indicating no structural damage to the nanorods. Fig. 1c shows the change of PL intensity 42 in percent, a shift in the spectral position of the PL in meV 44, and FWHM of the change in PL 48 during cross-linking, wherein the horizontal axis shows the applied dose in mC per cm². Unexpectedly the PL intensity 42 does not decrease due to any damage to the uppermost layer but instead increases. The shift of the PL is within the margin of error, and the FWHM decreases slightly. Figs. 1d and 1e show SEM images of a nanorod layer before 26 (Fig. 1d) and after cross-linking 28 (Fig. 1e). The general distribution as well as the stacking properties do not change. Bright spots after cross-linking can be attributed to metallic lead due to the electron beam. Figs. 1f and 1e show images of water droplets on a reference sample (Fig. 1f) and a cross-linked layer (Fig. 1g). While the reference layer is hydrophilic, the cross-linked layer becomes hydrophobic. As perovskite NCs are usually highly susceptible to water, this is an excellent method to overcome stability problems.

In particular, a PNC thin film or PNC assembly 10 is fabricated by spincoating PNCs, such as nanoplatelets (NPLs) 14, on a substrate 12, such as a 10 × 10 mm silicon substrate, which is then inserted into an ultra-high vacuum chamber with an electron gun attached (see Methods for details). An electron beam 24 is emitted from a cathode 20 and further focused via a Wehnelt cylinder 22 onto the PNCs. The electrons of the electron beam 24 break up intra-ligand carbon bonds before cross-linking 26, and inter-ligand double carbon bonds emerge after cross-linking 28. Due to a penetration depth of a couple of nanometers, only the uppermost layers form a protective network, while the rest of the approx. 100 nm thick perovskite layer remains pristine, consequently retaining its optical properties.

These properties are monitored through room temperature PL spectroscopy on PNC films before cross-linking 26 and after the cross-linking 28 (Figure 1b). Fig. 1b shows exemplary normalized PL spectra of a 3 ML nanorod before cross-linking 26 and after the cross-linking 28. The abscissa shows the energy 30 (energy [eV]) and the ordinate the normalized PL intensity 32 (PL intensity [norm.]). Neither full width- half maximum (FWHM) nor peak position change, indicating that the morphology of the PNCs does not change and no structural damage to the nanorods occurred.

To assess whether the electron-beam irradiation can lead to degradation of the PNC layer, the electron dosage (controlled by the irradiation time) was varied, and PL spectra of the different samples (Figure 1c) were compared. Fig. 1c shows the change of PL intensity 42 (ΔPL Int. [%]), the change of PL position 44 (ΔPL Pos. [meV]), and the change of FWHM 46 (Δ FWHM [meV]) during cross-linking. The abscissa shows the dose 40 (dose [mC/cm²]) and the field 48 indicates no vacuum. The total PL intensity is generally higher post-treatment, with no strong correlation to the electron dose. This increase can be attributed to a change in the film morphology induced by evaporation of residual solvent as the samples are put under vacuum. This is confirmed by samples introduced into the vacuum chamber but not irradiated with electrons, which show a comparable increase in PL intensity. This morphology change likely influences in the in- and out-coupling properties of the PNC layer.

To further investigate this phenomenon, a PNC layer was spincoated on FTO-mixed glass, which enables electron discharge during the cross-linking process. As the substrate is transmissive, the absorbance of the film can be measured. In the low energy regime before the exciton, absorbance peaks at 2.7 eV, the cross-linked and vacuum samples show significantly lower absorbance than the untreated sample. This indicates better in- and outcoupling efficiency and less scattering and explains the increased PL intensity.

The shift of the PL maximum in comparison to the untreated sample is negligible (1 to 4 meV), with a very slight increase in blueshift with increasing electron dose. Similarly, the width of the PL spectra, as determined by their full width-half maxima (FWHM), decreases slightly by 1-3 meV with a larger narrowing for higher doses. These results indicate a more uniform PNC size distribution likely due to smaller and defect-rich PNCs being less stable to electron irradiation. Scanning electron microscopy (SEM) images of the samples before 26 and after cross-linking 28 show that the films also do not change on a macroscopic scale (Figure 1d and 1e). Finding PL and SEM imaging, one would conclude that the microscopic properties of the PNC films remain essentially unperturbed by the cross-linking.

On a macroscopic scale however, the picture changes significantly. The water droplet on an untreated PNC film spreads over the surface, degrading the PNCs in the process (Figure 1f). In contrast, on a cross-linked PNC sample, the water droplet retains a high contact angle signifying a highly hydrophobic surface (Figure 1g). This effect confirms that cross-linking was effective and is extremely advantageous for device applications.

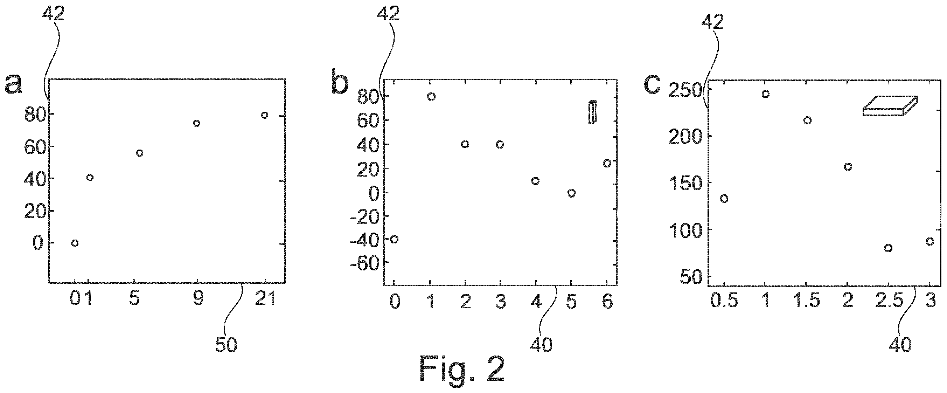

Fig. 2 shows photoluminescence intensity 42 development over time 50 (Fig. 2a). The initial increase due to the cross-linking process is by increased in- and outcoupling. Further increase is explained by vacancy filling of bromium and lead defects. Fig. 2b shows the change in PL intensity 42 and position of nanorods after three weeks of storage in ambient conditions compared to before treatment, depending on the dose 40. The untreated samples' intensity decreases by 40 percent and shifts by over 4 nm, while all cross-linked samples either increase their PL or stay constant. Higher doses have a lower PL indicating a tradeoff between damage by cross-linking and protection. Fig. 2c shows the change in PL intensity 42 and position of nanoplatelets after three weeks of storage in ambient conditions compared to before treatment, depending on the dose 40. No reference is shown because it has no measurable PL. Once again, the PL increases compared to before cross-linking. The lowest dose here does not contribute the most to an increase, indicating insufficient cross-linking for protection. Each graph in Figure 2 indicates the change of PL intensity in percent on the vertical axis. The graph in figure 2a indicates the time in days on the horizontal axis. The graphs in figures 2b and 2c indicate the dose in mC per cm² on the horizontal axis.

In particular, the immediate effects of cross-linking are obvious: increased hydrophobicity of the PNC surface, likely enhancing the film's long-term stability and an immediate increase of the PL intensity. To investigate the long-term effects, PL intensity of untreated and cross-linked films stored in ambient conditions over a period of three weeks was monitored. This is shown exemplarily for the sample illuminated with 1000 µC/cm² (Figure 2a), wherein the abscissa shows the time 50 (time [Day]) and the ordinate shows the change of PL intensity 42 (ΔPL Int. [%]). The immediate increase of PL intensity of 40% is followed by a gradual increase over the next three weeks. The intensity saturates at 180% of the initial PL intensity. This is a vast improvement over the untreated sample, its PL intensity degrades by 40% over the same time span.

PL intensity was monitored for the samples cross-linked at higher doses and the overall trend of increased PL intensity after three weeks was confirmed. At slightly higher electron doses the total PL intensity saturates at lower values of approximately 40 percent. The highest doses PL intensity initially increases, reaching a maximum after approximately 10 days and declining subsequently (Figure 2b), wherein the abscissa shows the dose 40 (dose [mC/cm²]) and the ordinate the change of PL intensity 42 (ΔPL Int. [%]) after 3 weeks. This dose dependence suggests that electron irradiation does degrade the PNC layer somewhat. The further increase after that is probably due to self-repair and Ostwald ripening of the PNCs, where primarily bromide and lead vacancies in the crystal structure can be filled and ligands can reattach (B. J. Bohn, Y. Tong, M. Gramlich, M. L. Lai, M. Döblinger, K. Wang, R. L. Z. Hoye, P. Müller-Buschbaum, S. D. Stranks, A. S. Urban, L. Polavarapu, J. Feldmann, Nano Lett. 2018, 18, 5231, the contents of which are incorporated by way of reference). Importantly, the PL spectra of the cross-linked PNCs remain essentially unchanged, indicating that colloidal stability is preserved. In contrast, the reference sample's PL, which was not cross-linked, shows a significant shift of 4.4 meV towards lower energy, indicating the emergence of larger NCs likely through fusing of adjacent PNCs (SI).

To confirm that the process is independent of the PNC structure, the measurements for 2D nanoplatelets were repeated, focusing on lower electron doses (Figure 2c), wherein the abscissa shows the dose 40 (dose [mC/cm²]) and the ordinate the change of PL intensity 42 (ΔPL Int. [%]) after 3 weeks. The observed behavior in these samples is very similar, with an overall increase of the PL intensity for all electron doses by up to 250%. Interestingly at 500 µC/cm², corresponding to half the lowest electron dose used on the nanorods, total PL increase after three weeks is less than for slightly higher electron doses. This indicates that the cross-linking process was not complete and the nanoplatelets are still prone to degradation in ambient conditions. The PL peak position shift is again minimal for all samples, indicating good stability. A reference sample is not shown here, as its PL vanished entirely after seven days. The higher surface of nanoplatelets explains both the lower stability when not cross-linked as well as the higher potential for self-repair.

While the stability against ambient conditions is important, for device fabrication stability to diverse solvents can be crucial for both process scalability as well as commercial viability. Stability to polar solvents was already demonstrated by using water (Figures 1f, 1g).

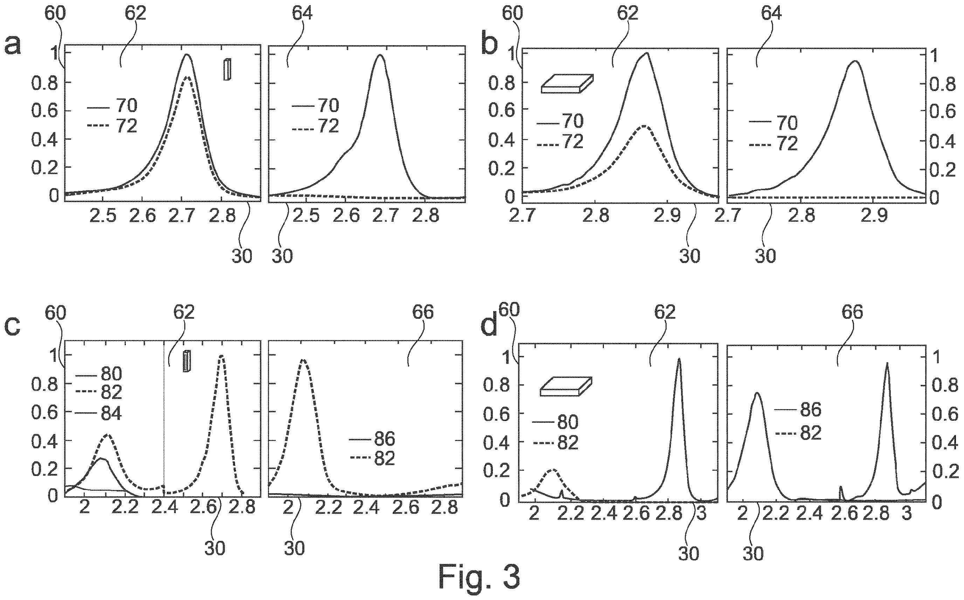

Fig. 3 shows the stability of a Perovskite nanocrystal (PNC) assembly, particularly the stability of nanorods to drenching in n-hexane.(Fig. 3a). The reference sample gets washed away entirely while the cross-linked layers stay intact. The decrease in intensity can be explained by the edge of the sample, which the electron beam does not reach, and which can consequently be washed away. Fig. 3b shows the stability of nanoplatelets to drenching in Hexane. Again, the reference sample gets washed away while the cross-linked layers stay intact. The cross-linked sample had a scratched surface by multiple measurements beforehand, which explains the more significant susceptibility to hexane. Fig. 3c shows the construction of a Perovskite heterostructure. An iodine-based perovskite is spincoated on top of the nanorod samples. Unlike usual, where the first layer would be washed away, and ion exchange would lead to the emergence of a single peak, there are two distinct peaks in the cross-linked sample. The initial material on the reference sample gets washed away as expected, and only the iodine peak remains. Fig. 3d shows that for the nanoplatelets, the cross-linked layer also protects the initial peak from any ion exchange, and there are two distinct peaks.

In particular, in Fig. 3 the abscissa shows the energy 30 (energy [eV]) and the ordinate the PL intensity 60 (PL Int. [arbitrary units]). Boxes on the left side indicate cross-linked samples 62, the above box on the right-side untreated samples 64, and the below box on the right-side reference samples 66. In the graphs 70 designates a pre-cross-link sample, 72 a post-cross-link sample, and 80 refers to pure cross-link, 82 to heterostructure, 84 to iodine reference, and 86 to untreated.

The cross-linked PNC assemblies have been subjected to n-hexane wash for nanorods and nanoplatelets to determine stability to nonpolar solvents (Figure 3a and b, respectively). This is done via a static spincoat with 50 µL of n-hexane to dissolve the layer and then spinning the substrate with the two-step parameters to sling away dissolved material. Whereas untreated PNC films are completely washed away, PL spectra of both types of PNCs shows no change in shape, only a slight reduction in overall intensity. Due to the cross-linking setup, substrate corners are not irradiated with electrons. These untreated parts outside the electron beam focus are dissolved and do not contribute to the total PL intensity indicated by the decrease in PL intensity. Nevertheless, this confirms that the cross-linked PNC samples are also stable to nonpolar solvents. This advantageous quality may be used to fabricate PNC heterostructures (Figure 3c). This is achieved by spincoating a layer of iodide-containing PNCs on top of the cross-linked bromide PNC layer. Normally, the surplus of iodide ions would lead to a replacement of the bromide ions within the PNCs, shifting the PL spectra from 2.7 eV to 2.1 eV, as observed for an untreated (reference) sample. However, in the heterostructure the PL peak of the bromide PNCs does not shift. Yet the corresponding peak to the iodide PNCs shows a slight blueshift, likely due to residual bromide ions permeating the not cross-linked iodide PNC layer. The heterostructure formation was successful for both nanorods and nanoplatelets (Figure 3d). In addition, shadow masks may be employed to selectively cross-linked parts of the sample. Consequently, it is possible to realize complex multilayer PNC heterostructures, enabling energy cascades.

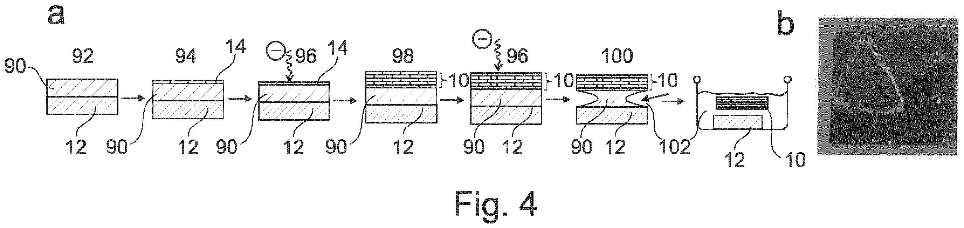

Fig. 4 schematically depicts a process of manufacturing a nanocrystal (NC) assembly 10, in particular a Perovskite nanocrystal (PNC) assembly, according to an optional embodiment. Fig. 4a shows a double spincoat and cross-link procedure is used to enable a perovskite nanocrystal layer wet transfer. A hexane resistant PMMA layer is spincoated on a silicon substrate. Subsequently, a thin perovskite layer is spincoated and cross-linked. As this cross-linked perovskite layer is then resistant to solvents, a thick layer of perovskite is spincoated on top and then cross-linked. Protected on both sides, the perovskite foil can then be wet-transferred via an acetone bath. In Fig. 4b, a cross-linked perovskite foil is shown that has PL despite swimming in acetone for 1.5 hours and is still emitting blue PL.

In particular, Fig. 4 shows a method to obtain a freestanding PNC sheet via wet transfer. To achieve this, a two-step cross-linking process was employed. This protects the PNC layer from both sides, enabling new fabrication methods (Figure 4a). First, a 10 µm thick layer of Poly(methyl 2-methylpropenoate) (PMMA) photoresist 90 is deposited, e. g. by spincoating 92, on a substrate 12, optionally a 10×10mm silicon substrate. Afterward, a 10 nm thick perovskite layer is spincoated 94 on top and cross-linked 96 with a dose of 6000 µC/cm² to ensure complete cross-linking. As this layer is resistant to n-hexane, a second 120 nm thick layer of PNCs is subsequently spincoated 98 and cross-linked 96 again at the same dose at the same spot. The result is an optically thick, pristine PNC layer protected on both sides by chemically and mechanically more stable perovskite-ligand networks. The PNC layer is then stripped from the substrate by dissolving the PMMA with acetone 100. This may be performed by immersing the PNC assembly 10 attached to the substrate 12 in an acetone bath 102. The PNC assembly 10 can then be easily transferred onto a new substrate and its mechanical stability is high enough to bridge millimeter-sized holes (Figure 4b). The retention of the strong blue PL emission is visible and the green emission on the sides is due to the experimental setup. This breakthrough provides an advantageous option for low-cost high-volume manufacturing. It also enables new research paths with suspended perovskite NCs.

In conclusion, cross-linking is a suitable method for protecting a perovskite NC layer. No indication of any significant structural or compositional damage can be seen, and the optical properties remain unperturbed. The long-term stability to ambient conditions is increased dramatically, and the PL even increases progressively over a few weeks, such as about two to about four weeks, or about three weeks, due to ripening effects previously masked by degradation in ambient conditions. The stability to solvents is also improved, enabling the realization of perovskite heterostructures of different chemical compositions without ion exchange and subsequent PL by mixed-composition crystals. The proposed double cross-linking and wet transfer approach enables producing a freestanding highly durable PNC sheet.

### Materials

Cs₂CO₃ (cesium carbonate, 99%), PbBr₂ (lead (II) bromide, ≥ 98%), oleic acid (technical grade, 90%) and oleylamine (technical grade, 70%) were purchased from Sigma Aldrich. Toluene (for HPLC, >99%), n-hexane (for HPLC, >97%) and acetone (for HPLC, >99.9%) were purchased from VWR Chemicals and n-octane (99%) was purchased from Acros Organics. All chemicals were used without further purification.

### Precursor preparation

The Cs-oleate precursor was prepared by dissolving Cs₂CO₃ (0.1 mmol, 32.5 mg) in oleic acid (10 mL) under continuous stirring at 85 °C for up to three hours until a clear solution is obtained. The PbBr₂-precursor was prepared by dissolving PbBr₂ (0.1 mmol, 36.7 mg) in toluene (10 mL) and oleic acid and oleylamine (100 µL each) under continuous stirring at 85 °C for up to three hours until a clear solution is obtained. The PbBr₂-enhancement solution was prepared by dissolving PbBr₂ (0.1 mmol, 36.7 mg) in either n-hexane or n-octane (10 mL) and oleic acid and oleylamine (100 µL each) under continuous stirring at 85 °C for up to three hours until a clear solution is obtained.

### Synthesis of anisotropic CsPbBrs NCs

The synthesis is carried out at room temperature (20-22°C) in ambient atmosphere (30-40% humidity). In a glass vial, Cs-oleate precursor (300 µL) is added to a certain volume of PbBr₂-precursor (6000 µL for 2ML NPLs, 3000 µL for 3ML NRs) under vigorous stirring at 1200 rpm. After 10-15 s, acetone (4000 µL) is added to initiate the formation and precipitation of perovskite NCs. The reaction mixture is stirred for another 60 s and then centrifuged at 4000 rpm (Hettich Rotina 380R, 117 mm) for 3 minutes. The supernatant is discarded, the precipitate is redispersed in either n-hexane or n-octane (450 µL) and enhancement solution (50 µL) is added to improve the stability and emission properties of colloidal perovskite NCs.

### Methods

Boron-doped p-type silicon wafers cut into 10*10mm pieces were purchased at Siegert wafer and cleaned with acetone and isopropanol baths in ultrasonic bath. Two-step spincoats are done on a silicon substrate at 1400 rpm for 5 seconds and 1700 rpm for 7 seconds with 1500 and 2000 rpm, respectively. The samples are dried afterward for an hour, then inserted in a six-piece sample holder and mounted into a load lock. Subsequently, the load lock is pumped down to 2*10^-6 mbar. Then the samples are transferred into the main chamber (9*10^-8 mbar) and cross-linked sample by sample with an EFG-7 electron gun by Kimball Physics. The electron current for the dose is measured at the Faraday gate before opening it. After cross-linking all samples, the holder is transferred back to the load lock, which is subsequently vented. The spectral PL of the samples before and afterward is measured using a Fluoromax 4 Plus by HORIBA Scientific. The same instrument was used for absorbance measurements. The absorbance measurements are carried out on cut TEC15 FTO-mixed soda lime glass substrates with a FTO thickness of 400-450nm and a substrate thickness of 2.1 mm supplied by Ossila. Samples for the perovskite foil are spincoated with PMMA (3.5% solution of PMMA in acetone) at 1000rpm and dried on a hotplate at 170 °C for 30 minutes. The thin perovskite layer is spincoated at 4000 rpm for 30 seconds, the second layer is carried out following the recipe above. AZ125 NXT by Microchemicals is used as an alternative for PMMA and processed by manufacturer specifications for a 125 µm thick layer.

### Reference signs

- 10: NC assembly
- 12: substrate
- 14: NPLs
- 20: cathode
- 22: Wehnelt cylinder
- 24: electron beam
- 26: before cross-linking
- 28: after cross-linking
- 30: Energy
- 32: normalized PL intensity
- 40: dose
- 42: change of PL intensity
- 44: change of PL position
- 46: change of FWHM
- 48: field
- 50: time
- 60: PL intensity
- 62: cross-linked samples
- 64: untreated samples
- 66: reference samples
- 70: pre-cross-link sample
- 72: post-cross-link sample
- 80: pure cross-link
- 82: heterostructure
- 84: iodine reference
- 86: untreated
- 90: PMMA photoresist
- 92: spincoating photoresist
- 94, 98: spincoating PNC layer
- 96: cross-linking
- 100: dissolving the PMMA with acetone
- 102: acetone bath
- 200: method
- 210: providing
- 220: mixing
- 230: subjecting
- 240: providing additional nanocrystals (NCs)
- 300: direct-gap semiconductor
- 310: light-emitting diode
- 320: solar cell

## Claims

1. A method (200) of manufacturing a nanocrystal (NC) assembly (10), comprising:
- providing (210) nanocrystals (NCs),
**characterized in that** the method further comprises:
- mixing (220) the nanocrystals (NCs) with an alkyl carboxylic acid, an alkyl amine and/or an alkyl alcohol, wherein at least one of the alkyl carboxylic acid, alkyl amine, and alkyl alcohol is unsaturated, to obtain ligand-mixed nanocrystals (NCs), and
- subjecting (230) the ligand-mixed nanocrystals (NCs) to a collimated electron beam to obtain the nanocrystal (NC) assembly (10).

2. The method of claim 1, wherein the nanocrystals (NCs) are Perovskite nanocrystals (PNCs) and/or are in form of nanorods and/or nanoplatelets.

3. The method of claim 1 or 2, wherein the nanocrystals (NCs) are Perovskite nanocrystals (PNCs) that comprise ABClₓBr_{y}I_{z} with A = Rb or Cs, B = Pb or Sn, 0 ≤ x ≤ 3, 0 ≤ y ≤ 3, and 0 ≤ z ≤ 3 with the proviso that x + y + z = 3.

4. The method of any of the preceding claims, wherein the alkyl carboxylic acid, the alkyl amine and alkyl alcohol comprise independently from each other 12 to 22 C-atoms.

5. The method of any of the preceding claims, wherein a volume ratio of the alkyl amine and/or alkyl alcohol to the unsaturated alkyl carboxylic acid is from about 1:2 to about 2:1.

6. The method of any of the preceding claims, wherein the nanocrystal (NC) assembly (10) is resistant to washing with polar solvents and apolar solvents, wherein the polar solvents include solvents with a polarity that is lower than the polarity of water and the apolar solvents include solvents with a polarity that is higher than the polarity of n-hexane.

7. The method of any of the preceding claims, wherein subjecting (230) the ligand-mixed nanocrystals (NCs) to a collimated electron beam comprises exposing the ligand-mixed nanocrystals (NCs) to a dose of about 5 × 10² µC/cm² to about 2 × 10⁴ µC/cm².

8. The method of any of the preceding claims, further comprising providing additional nanocrystals (NCs) (240) on the nanocrystal (NC) assembly (10).

9. The method of any of the preceding claims, wherein providing (210) nanocrystals (NCs) comprises depositing the nanocrystals (NCs) on a substrate, particularly a silicon substrate.

10. The method of claim 8 or 9, wherein depositing the nanocrystals (NCs) includes spin-coating or drop-casting.

11. The method of any of claims 8 to 10, wherein the nanocrystals (NCs) are deposited with a thickness of about 10 nm to about 300 nm, wherein the thickness is measured according to the description.

12. The method of any of claims 8 to 11, further comprising stripping off the nanocrystal (NC) assembly (10) from the substrate.

13. A nanocrystal (NC) assembly (10) obtained by the method of any of the preceding claims.

14. A direct-gap semiconductor (300) comprising the nanocrystal (NC) assembly (10) of claim 13.

15. A light-emitting diode (310) comprising the nanocrystal (NC) assembly (10) of claim 13 or the direct-gap semiconductor (300) of claim 14, or a solar cell (320) comprising the nanocrystal (NC) assembly (10) of claim 13 or the direct-gap semiconductor (300) of claim 14.
